# EUROPÄISCHE PATENTSCHRIFT

(11) **EP 1 145 279 B1**
(45) Veröffentlichungstag und Bekanntmachung des Hinweises auf die Patenterteilung: **09.04.2008**
(21) Anmeldenummer: 00902538.8
(22) Anmeldetag: 05.01.2000
(51) Int. Cl.: H01L 21/00, H01L 29/51

(54) **HALBLEITERBAUELEMENT MIT EINER WOLFRAMOXIDSCHICHT UND VERFAHREN ZU DESSEN HERSTELLUNG**
SEMICONDUCTOR ELEMENT WITH A TUNGSTEN OXIDE LAYER AND METHOD FOR ITS PRODUCTION
COMPOSANT SEMI-CONDUCTEUR AVEC UNE COUCHE D'OXYDE DE TUNGSTENE ET SON PROCEDE DE FABRICATION

(30) Priorität: 14.01.1999 DE 19901210
(43) Veröffentlichungstag der Anmeldung: 17.10.2001
(73) Patentinhaber: Infineon Technologies AG, 81669 München (DE)
(72) Erfinder: SCHREMS, Martin, D-01465 Langebrück (DE); DRESCHER, Dirk, D-01465 Langebrück (DE); WURZER, Helmut, D-01109 Dresden (DE); TEWS, Helmut, Poughkeepsie, NY 12603 (US)
(74) Vertreter: Zimmermann & Partner
(86) Internationale Anmeldenummer: PCT/DE2000/000047
(87) Internationale Veröffentlichungsnummer: WO 2000/041459

(56) Entgegenhaltungen:
- EP-A- 0 418 540
- WO-A-97/02605
- WO-A-98/10925
- US-A- 5 189 503
- US-A- 5 225 286
- US-A- 5 420 060
- PATENT ABSTRACTS OF JAPAN vol. 1995, no. 8, 29. September 1995 (1995-09-29) & JP 07 135202 A (MIYAGI OKI DENKI KK), 23. Mai 1995 (1995-05-23)
- ROTHSCHILD M ET AL: "EXCIMER-LASER-INDUCED SUB-0.5UM PATTERNING OF WO3 THIN FILMS" APPLIED PHYSICS LETTERS,US,AMERICAN INSTITUTE OF PHYSICS. NEW YORK, Bd. 59, Nr. 14, 30. September 1991 (1991-09-30), Seiten 1790-1792, XP000250019 ISSN: 0003-6951
- JOSHI R V: "NON-SELF-LIMITING NATURE OF SILICON REDUCTION OF WF6 IN COLD WALL SYSTEMS" JOURNAL OF APPLIED PHYSICS,US,AMERICAN INSTITUTE OF PHYSICS. NEW YORK, Bd. 71, Nr. 3, 1. Februar 1992 (1992-02-01), Seiten 1428-1441, XP000885063 ISSN: 0021-8979 in der Anmeldung erwähnt
- D. WIDMANN, H. MADER, H. FRIEDRICH: "Technologie hochintegrierter Schaltungen" SPRINGER * Seite 33 * * Seiten 57-58 * * Seite 90 *

## Beschreibung

Die Erfindung betrifft ein Verfahren zur Herstellung eines Halbleiterbauelements insbesondere eines Halbleiterbauelements mit einem Gatedielektrikum eines Feldeffekttransistors und/oder mit einem sogenannten "storage node dielektrikum" in einer Speicherzelle.

Zur Erhaltung bzw. Steigerung der internationalen Wettbewerbsfähigkeit ist es notwendig, die Kosten, die zur Realisierung einer bestimmten elektronische Funktion aufzuwenden sind, ständig zu senken und somit die Produktivität kontinuierlich zu steigern. Der Garant für die Produktivitätssteigerung in den letzten Jahren waren und sind dabei die CMOS-Technologie bzw. die DRAM-Technologie. Dabei erreichten diese beiden Technologien die Produktivitätssteigerung durch fortschreitende Strukturverkleinerung.

Die fortschreitende Strukturverkleinerung der MOS-Transistoren bringt es jedoch mit sich, daß zur wirksamen Ansteuerung der Transistoren immer dünnere dielektrische Schichten als Gatedielektrika verwendet werden müssen. Wird, wie heute allgemein üblich, Siliziumdioxid als Gatedielektrikum verwendet, so müßte die Schichtdicke des Gatedielektrikums in einer 0,1 µm Technologie weniger als 1,5 nm betragen. Es ist jedoch sehr schwer, derartig dünne Siliziumdioxidschichten mit ausreichender Genauigkeit, reproduzierbar herzustellen. Abweichungen von nur 0,1 nm bedeuten Schwankungen in der Schichtdicke in der Größenordnung von 10%. Darüber hinaus kommt es bei derartig dünnen Siliziumdioxidschichten zu hohen Leckströmen durch die Siliziumdioxidschicht, da durch den Effekt des quantenmechanischen Tunnels die Ladungsträger die durch die Siliziumdioxidschicht erzeugte Potentialbarriere überwinden können.

Bei der Entwicklung von hochintegrierten Speicherbausteinen, muß die Zellkapazität einer einzelnen Speicherzelle trotz der fortschreitenden Miniaturisierung beibehalten oder sogar noch verbessert werden. Zur Erreichung dieses Ziels werden ebenfalls immer dünnere dielektrische Schichten, üblicherweise Siliziumoxid- bzw. Oxid-Nitrid-Oxidschichten (ONO), sowie gefaltete Kondensatorelektroden (Trench-Zelle, Stack-Zelle) verwendet. Jedoch kommt es auch bei der Reduzierung der Dicke des Speicherdielektrikums zu einer deutlichen Erhöhung der Leckströme (Tunnelströme) durch das Dielektrikum.

Es wurde daher vorgeschlagen, die üblichen Siliziumdioxidschichten bzw. Oxid-Nitrid-Oxid-Schichten durch Materialien mit einer höheren relativen Dielektrizitätskonstanten (εᵣ) zu ersetzen. Mit einem derartigen Material können vergleichsweise dicke Schichten von mehr als 5 nm als Gatedielektrikum bzw. Speicherdielektrikum verwendet werden, die jedoch elektrisch einer Siliziumdioxidschicht von deutlich kleiner als 5 nm entsprechen. Die Dicke einer derartigen Schicht ist leichter zu kontrollieren und der Tunnelstrom durch die Schicht ist deutlich vermindert.

Als Materialien für das Gatedielektrikum wurden beispielsweise, Titanoxid oder Tantalpentoxid bzw. Schichtstapel aus Oxid/Titanoxid oder Oxid/Tantalpentoxid vorgeschlagen. Als Materialien für das Speicherdielektrikum kommen beispielsweise Bariumstrontiumtitanat (BST, (Ba,Sr)TiO₃), Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) zum Einsatz.

Leider weisen diese Materialien für ihre neue Verwendungen jedoch eine Reihe von Nachteilen auf. So werden zur Herstellung eines Gatedielektrikums aus Titanoxid oder Tantalpentoxid üblicherweise CVD-Prozesse eingesetzt. Die so hergestellten Schichten weisen jedoch Verunreinigungen auf, die auf die bei den CVD-Verfahren verwendeten Prozeßgase zurückzuführen sind. Diese Verunreinigungen führen zu Ladungen und sogenannten "Traps" in den Schichten, die wiederum die Funktion des Transistors negativ beeinflussen. Außerdem ergeben diese Schichten bzw. Schichtstapel in der Regel keine ausreichende Erhöhung der Dielektrizitätskonstanten (εᵣ).

Bei den neuen Materialien, die als Speicherdielektrikum eingesetzt werden, hat sich herausgestellt, daß sie zu den chemisch nur schwer oder nicht ätzbaren Materialien gehören, bei denen der Ätzabtrag, auch bei der Verwendung "reaktiver" Gase, überwiegend oder fast ausschließlich auf dem physikalischen Anteil der Ätzung beruht. Wegen der geringen oder fehlenden chemischen Komponente der Ätzung liegt der Ätzabtrag der zu strukturierenden Schicht in der selben Größenordnung wie der Ätzabtrag der Maske bzw. der Unterlage (Ätzstoppschicht), d.h. die Ätzselektivität zur Ätzmaske bzw. Unterlage ist im allgemeinen klein (zwischen etwa 0,3 und 3,0). Dies hat zur Folge, daß durch die Erosion von Masken mit geneigten Flanken und die unvermeidliche Facettenbildung (Abschrägung, Taperung) auf den Masken nur eine geringe Maßhaltigkeit der Strukturierung gewährleistet werden kann. Diese Facettierung beschränkt somit die bei der Strukturierung kleinsten erzielbaren Strukturgrößen sowie die erzielbare Steilheit der Profilflanken bei den zu strukturierenden Schichten.

Weiterhin sind zur Herstellung von BST-, PZT- oder SBT-Schichten komplizierte und teure Abscheideverfahren, sowie schwierig zu prozessierende Barrierenschichten wie Platin oder Rhutenium nötig. Bedingt durch eine mangelnde thermische Stabilität können BST-Schichten darüber hinaus nicht für sogenannte "Deep Trench"-Kondensatoren verwendet werden.

Aus US 5 225 286 ist bekannt, ein Mischdielektrikum aus Tantaloxid und Wolframoxid zu verwenden. Dadurch sollen die Dielektrizitätskonstante erhöht und gleichzeitig die Isolationseigenschaften verbessert werden.

Ein Mehrschichtdielektrikum für Speicherkondensatoren bestehend aus einer Zirkonium-dotierten Tantaloxidschicht sowie einer dünnen Wolframoxidschicht wird in US 5,189,503 beschrieben.

In JP 07-135202 wird die Herstellung einer Wolframoxidschicht beschrieben, wobei eine Wolframschicht unter Verwendung von WF₆ abgeschieden wird, die nachträglich bei 600°C thermisch oxidiert wird.

Es ist daher eine der Aufgaben der vorliegenden Erfindung, ein Verfahren zur Herstellung eines Halbleiterbauelements anzugeben, das die genannten Probleme vermeidet oder deutlich vermindert. Diese Aufgabe wird von den Verfahren gemäß Patentansprüchen 1 und 4 gelöst.

Weitere vorteilhafte Ausführungsformen, Ausgestaltungen und Aspekte der vorliegenden Erfindung ergeben sich aus den Unteransprüchen der Beschreibung und den beiliegenden Zeichnungen.

Mittels des erfindungsgemäßen Verfahrens kann ein Halbleiterbauelement mit zumindest einer Schicht aus Wolframoxid (WOₓ), gegebenenfalls einer strukturierten Schicht aus Wolframoxid (WOₓ), hergestellt werden. Das durch das Verfahren gemäß Anspruch 1 hergestellte Halbleiterbauelement zeichnet sich durch eine relative Dielektrizitätskonstante (εᵣ) der Wolframoxidschicht (WOₓ) von größer als 50 aus. Bei den Verfahren gemäß den Anspüchen 1 und 4 werden Halbleiterbauelemente hergestellt, wobei die Wolframoxidschicht in einer kristallinen oder gesinterten Phase vorliegt.

Das hergestellte Halbleiterbauelement besitzt den Vorteil, daß sich mit Wolframoxidschichten (WOₓ), beispielsweise x=2 - 3) auf relativ einfache Weise sehr große relative Dielektrizitätskonstanten (εᵣ) erzeugen lassen. Das Halbleiterbauelement besitzt darüber hinaus den Vorteil, daß die bisher in der Halbleitertechnik eingesetzten Anlagen ebenfalls für die Erzeugung von Wolframoxidschichten (WOₓ) eingesetzt werden können. Speziell angepaßte und damit teure Anlagen müssen nicht verwendet werden. Das zur Erzeugung der Wolframoxidschichten (WOₓ) eingesetzte Wolfram diffundiert nur sehr schlecht in Silizium, so daß sich bei dem so hergestellten Halbleiterbauelement nur ein geringes Kontaminationsrisiko ergibt. Die Anwendung von Wolframoxidschichten (WOₓ) ist jedoch nicht nur auf die Siliziumtechnologie beschränkt, sondern diese Schichten können auch im Zusammenhang mit anderen Halbleitern beispielsweise GaAs verwendet werden.

Bevorzugt wird die Wolframoxidschicht (WOₓ) als Speicher-, Gate-, Tunnel- oder STI-Liner-Dielektrikum eingesetzt.

Weiterhin ist bevorzugt, wenn die relative Dielektrizitätskonstante (εᵣ) der Wolframoxidschicht größer als 100, insbesondere größer als 150 ist.

Das Halbleiterbauelement kann zumindest einen Schichtstapel aus einer wolframhaltige Schicht und einer Wolframoxidschicht (WOₓ), gegebenenfalls einen strukturierten Schichtstapel aus einer wolframhaltige Schicht und einer Wolframoxidschicht (WOₓ), aufweisen.

Weiterhin kann das Halbleiterbauelement zumindest einen Schichtstapel aus einer Wolframoxidschicht (WOₓ) und zumindest einer Barriereschicht, gegebenenfalls einen strukturierten Schichtstapel aus einer Wolframoxidschicht (WOₓ) und zumindest einer Barriereschicht, aufweisen.

Bevorzugt wird die wolframreiche Schicht aus Wolfram, Wolframsilizid, oder Wolframnitrid gebildet.

Weiterhin ist es bevorzugt, wenn die Barriereschicht aus Siliziumoxid, Siliziumnitrid, Oxynitrid, Wolframnitrid oder Titannitrid gebildet wird.

Das erfindungsgemäße Verfahren gemäß Anspruch 1 zur Herstellung eines Halbleiterbauelements, das eine Wolframoxidschicht aufweist, ist durch folgende Schritte gekennzeichnet:
a) eine wolframhaltige Schicht wird bereitgestellt,
b) die wolframhaltige Schicht wird in einer sauerstoffhaltigen Atmosphäre bei einer Temperatur von 500 bis 1200°C thermisch oxidiert, und
c) die Schicht aus Wolframoxid wird nach der thermischen Oxidation einer Wärmebehandlung bei einer Temperatur zwischen 550 bis 1100°C, bevorzugt 700 bis 1100°C, in einer inerten Atmosphäre unterzogen, so daß eine Schicht aus Wolframoxid (WOₓ) in einer kristallinen oder gesinterten Phase und mit einer relativen Dielektrizitätskonstante (εᵣ) größer als 50 erzeugt wird.

Bevorzugt wird als wolframhaltige Schicht eine Schicht aus Wolfram, Wolframsilizid oder Wolframnitrid verwendet.

Weiterhin ist es bevorzugt, wenn die wolframhaltige Schicht mit einem CVD-Verfahren oder einem PVD-Verfahren bereitgestellt wird.

Gemäß dem Verfahren des Anspruchs 1 wird nach der thermischen Oxidation die Schicht aus Wolframoxid (WOₓ) einer Wärmebehandlung bei einer Temperatur zwischen 550 bis 1100°C, bevorzugt 700 bis 1100°C, unterzogen. Dabei wird die Wärmebehandlung in einer inerten Atmosphäre durchgeführt.

Darüber hinaus wird erfindungsgemäß ein weiteres Verfahren zur Herstellung eines Halbleiterbauelements, das eine Wolframoxidschicht aufweist, bereitgestellt. Das erfindungsgemäße Verfahren ist durch folgende Schritte gekennzeichnet:
a) eine Oberfläche des Halbleiterbauelements wird bereitgestellt;
b) Wolframfluorid und Wasser werden im gasförmigen Zustand auf die Oberfläche geführt, so daß eine Schicht aus Wolframoxid (WOₓ) erzeugt wird; und
c) die Schicht aus Wolframoxid wird einer Wärmebehandlung bei einer Temperatur zwischen 550 bis 1100 °C, bevorzugt 700 bis 1100 °C, in einer inerten Atmosphäre unterzogen, so daß eine Schicht aus Wolframoxid (WOₓ) in einer kristallinen oder gesinterten Phase erzeugt wird.

Die Schicht aus Wolframoxid (WOₓ) wird einer Wärmebehandlung bei einer Temperatur zwischen 550 bis 1100°C, bevorzugt 700 bis 1100°C, unterzogen. Dabei wird die Wärmebehandlung in einer inerten Atmosphäre durchgeführt.

Zwar lassen sich Wolframoxidschichten deutlich leichter als beispielsweise ferroelektrische Schichten oder Platinschichten strukturieren. Trotzdem gehören Wolframoxidschichten zu den Schichten, die sich, bei den üblichen Strukturierungsverfahren, im wesentlichen nur durch eine physikalischen Ätzkomponente ätzen lassen und die dementsprechend gegenüber anderen Schichten nur eine geringe Selektivität aufweisen. Daher wird weiterhin ein Verfahren zur Herstellung einer strukturierten Wolframoxidschicht bereitgestellt. Das Verfahren ist durch folgende Schritte gekennzeichnet:
a) eine Wolframoxidschicht wird bereitgestellt,
b) auf die Wolframoxidschicht wird eine Maske aufgebracht, und
c) die Wolframoxidschicht wird entsprechend der Maske in einer oxidierenden Atmosphäre bei einer Temperatur größer als 130°C trocken geätzt, wobei die oxidierende Atmosphäre zumindest eine Halogenverbindung, insbesondere CF₄, aufweist.

Das Verfahren besitzt den Vorteil, daß die Wolframoxidschicht im wesentlichen chemisch, auch ohne physikalische Ätzkomponente trocken geätzt werden kann. Dementsprechend weist das Verfahren eine hohe Selektivität gegenüber anderen Materialien wie beispielsweise Silizium oder Siliziumoxid auf.

Weiterhin ist es bevorzugt, wenn die Maske eine Polysiliziummaske ist.

Darüber hinaus ist es bevorzugt, wenn die Ätztemperatur zwischen 200°C und 300°C, insbesondere etwa 250°C beträgt. Und insbesondere ist bevorzugt, wenn der Anteil der Halogenverbindung in der oxidierenden Atmosphäre zwischen 1 und 10% beträgt.

Die Erfindung wird nachfolgend anhand von Figuren der Zeichnung näher dargestellt. Es zeigen:
Figuren 1 bis 4 eine schematische Darstellung einer Ausführungsform der erfindungsgemäßen Verfahren, und
Figuren 5 bis 6 eine schematische Darstellung einer weiteren Ausführungsform der erfindungsgemäßen Verfahren.

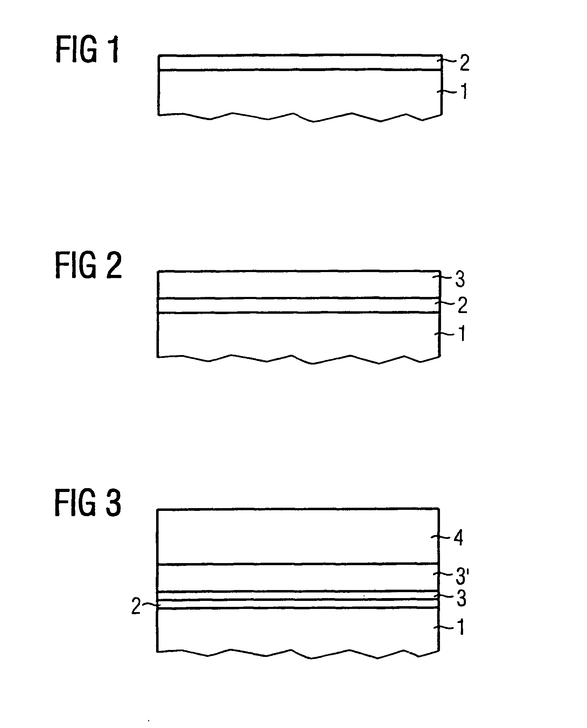

Figur 1 zeigt einen Ausschnitt eines Siliziumwafers mit einem Siliziumsubstrat 1. Der in Figur 1 gezeigte Zustand eines Siliziumwafers entspricht beispielsweise dem Zustand, den ein Siliziumwafer in einem Standard-CMOS Prozeß annimmt, nachdem die Wannen der CMOS-Transistoren und die Isolation (nicht gezeigt) der einzelnen Transistoren bereits erzeugt worden sind.

Auf die Oberfläche des Siliziumsubstrats 1 wird nun eine etwa 1 bis 5 nm dicke Siliziumdioxidschicht 2 als Barriereschicht. Diese Oxidschicht 2 kann beispielsweise durch eine thermische Oxidation erzeugt werden. Wird die thermische Oxidation in einer Atmosphäre durchgeführt, die zusätzlich NO- bzw. N₂O-Moleküle enthält, so läßt sich eine nitridierte Siliziumdioxidschicht 2 herstellen. Siliziumdioxidschichten weisen eine extrem niedrige Trapdichte auf, was positive Auswirkungen auf die Funktion des noch zu erzeugenden Transistors hat.

Wie bereits in der Einleitung erwähnt ist es schwierig, die Dicke einer solch dünnen Oxidschicht genau zu kontrollieren. Da diese Oxidschicht jedoch nur eine Vorstufe zur Erzeugung des eigentlichen Gatedielektrikums ist, können Schwankungen in der Schichtdicke der Oxidschicht 2 hingenommen werden, ohne daß dies negative Auswirkungen auf die Funktion des noch zu erzeugenden Transistors hat.

Auf die Oxidschicht 2 wird nachfolgend eine wolframhaltige Schicht 3 aufgebracht. Diese wolframhaltige Schicht 3 kann eine reine Wolframschicht, eine Wolframnitrid- oder eine Wolframsilizidschicht sein. Die wolframhaltige Schicht 3 wird beispielsweise durch einen Sputterprozeß (PVD-Verfahren) oder durch eine CVD-Verfahren erzeugt.

Soll ein CVD-Verfahren verwendet werden, kann auf eine Reihe von Verfahren zurück gegriffen werden:
CVD W (auf Silizium, nicht selektiv)
   z.B. WF₆ + SiH₄ → W + Gase (Keimschicht)
   z.B. WF₆ + H₂ → W + Gase (Bulkschicht)
CVD W (auf Silizium, selektiv zu Nitrid, Oxid):
   z.B. 2 WF₆ 3 Si→ 2 W + 3 (SiF₄)
   (ein derartiges Verfahren wird von R.V.Joshi et al., in J.Appl.Phys. 71(3) Februar 1, 1992, pp. 1428 beschrieben)
   z.B. WF₆ + H₂ → W + Gase
CVD WSiₓ :
   z.B. WF₆ + SiH₂Cl₂ → WSiₓ (z.B. x=2-3) + Gase
   (ebenfalls R.V.Joshi et al., J.Appl.Phys. 71(3) February 1, 1992, pp. 1428)
CVD WN (Wolframnitrid, z.B. W₂N):
   z.B. 4 WF₆ + N₂ + 12H₂ (Plasma CVD) → 4 W₂N + 24 (HF) (z.B. bei einer Temperatur von 350-400°C)

Die Schichtdicke der so erzeugten wolframhaltigen Schicht 3 beträgt etwa 10 bis 20 nm. Die sich daraus ergebende Situation ist in Fig. 2 gezeigt.

Anschließend wird die wolframhaltige Schicht 3 durch eine thermische Oxidation in eine Wolframoxidschicht 3' umgewandelt. Die Umwandlung findet einer Sauerstoffatmosphäre (beispielsweise O₂ oder H₂O) bei einer Temperatur von 500 bis 1200°C statt. Bei der Verwendung einer reinen Wolframschicht oder der Verwendung einer Wolframsilizidschicht sollte die Temperatur etwa 600°C nicht übersteigen oder eine sogenannte "low thermal budget" RTO ("Rapid Thermal Oxidation") durchgeführt werden, um zu verhindern, daß Silizium in die wolframhaltige Schicht 3 eindiffundiert und eine Oxidation der wolframhaltigen Schicht 3 verhindert wird.

Die thermische Oxidation der wolframhaltigen Schicht 3 führt zu einer Wolframoxidschicht 3', die kaum Verunreinigungen und die eine relative Dielektrizitätskonstante (εᵣ) größer als 50 aufweist. Die Schichten und die Prozeßparameter können dabei so gewählt werden, daß die wolframhaltigen Schicht 3 vollständig in die Wolframoxidschicht 3' umgewandelt wird oder daß ein Teil der wolframhaltigen Schicht 3 nicht oxidiert wird.

Durch eine nachfolgende Wärmebehandlung bei einer Temperatur von etwa 550 bis 1100°C in einer inerten Atmosphäre läßt sich eine Wolframoxidschicht 3' (WOₓ, beispielsweise x=2 - 3) in einer kristallinen oder gesinterten Phase (beispielsweise Phasen mit einer orthorhombische oder tetragonalen Symmetrie) erzeugen. Diese Wärmebehandlung kann bereits direkt im Anschluß an die Erzeugung der Wolframoxidschicht 3' erfolgen. Sie kann aber auch erst in einem späteren Prozeßschritt in der Herstellung einer integrierten Schaltung durchgeführt werden.

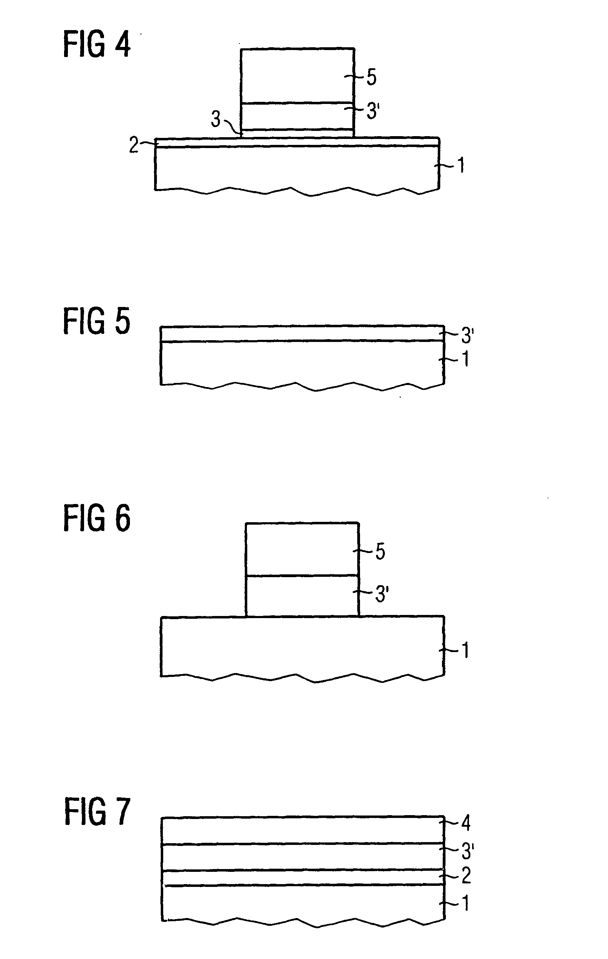

Der in Fig. 3 gezeigte Schichtstapel ist sehr gut für die Verwendung in einem MOS-Transistor geeignet, da, wie bereits erwähnt, die Siliziumdioxidschicht 2 (Barriereschicht) eine extrem niedrige Trapdichte aufweist. Für ein Speicherdielektrikum ist dies nicht unbedingt erforderlich, so daß für diese Anwendung auf die Siliziumdioxidschicht 2 auch verzichtet werden kann. Der nach der thermischen Oxidation gegebenenfalls noch übrig gebliebenen Teil der wolframreichen Schicht 3 (beispielsweise Wolframnitrid) übernimmt dann die Funktion einer (leitenden) Barriereschicht. Auf diese Weise ist eine sehr große Kapazität mit einer einfachen und kostengünstigen Prozeßführung erzielbar. Ein entsprechender Schichtstapel aus einer leitenden Wolframnitridschicht 2 (Barriereschicht und unter Elektrode), Wolframoxidschicht 3' und einer leitenden Wolframnitridschicht 4 (obere Elektrode) auf einem Siliziumsubstrat 1 ist in Figur 7 gezeigt.

Es folgt die Erzeugung einer leitenden Schicht 4 auf der Wolframoxidschicht 3'.Die sich daraus ergebende Situation ist in Fig. 3 gezeigt. Je nach verwendetem Prozeß kann vor der leitenden Schicht 4 jedoch noch eine weitere Barriereschicht beispielsweise eine Wolframnitridschicht (nicht gezeigt) abgeschieden werden. Die leitende Schicht 4 bildet beispielsweise die Gateelektrode eines MOS-Transistors und besteht üblicherweise aus dotiertem Polysilizium.

Es folgt eine Phototechnik, bei der die Polysiliziumschicht 4 strukturiert wird, so daß die Gatebahnen 5 erzeugt werden. Die Gatebahnen 5 bilden wiederum eine Maske zur nachfolgenden Ätzung der Wolframoxidschicht 3'. Als Ätzgas wird eine Mischung aus CF₄ und O₂ verwendet. Die Temperatur der Ätzung beträgt etwa 250°C. Dabei wird das Ätzgas durch eine HF-Einkopplung oder eine Mikrowellenanregung zur Bildung eines Plasmas angeregt. Das Verhältnis von CF₄ zu O₂ beträgt etwa 2% zu 98%.

Für die Ätzung selbst ist das frei werdende Fluor und die damit verbunden Reaktion des Wolframoxids mit dem Fluor verantwortlich. Es bilden sich flüchtige Wolfram-Fluor-Verbindungen. Der Sauerstoff übernimmt die Aufgabe als Passivator für das (Poly) Silizium. Durch Sauerstoff bildet sich SiO₂ dessen Bindungsenergie (ohne den Einsatz von zusätzlicher Ionenenergie) zu hoch ist um durch den geringen Fluoranteil signifikant geätzt zu werden. Die Ätzung der Wolframoxidschicht erfolgt daher sehr selektiv zu (Poly)Silizium bzw. zu Siliziumoxid. Die daraus ergebende Situation ist in Figur 4 gezeigt.

Der Prozeß zur Herstellung des Transistors kann dann gemäß einem Standard-CMOS Verfahren fortgesetzt werden, um den vollständigen Transistor zu erzeugen. Diese Schritte sind an sich bekannt, so daß auf sie nicht weiter eingegangen werden muß.

Figur 5 zeigt einen Ausschnitt eines Siliziumwafers mit einem Siliziumsubstrat 1. Der in Figur 5 gezeigte Zustand eines Siliziumwafers entspricht wiederum dem Zustand, den ein Siliziumwafer in einem Standard-CMOS Prozeß annimmt, nachdem die Wannen der CMOS-Transistoren und die Isolation (nicht gezeigt) der einzelnen Transistoren bereits erzeugt worden sind.

Auf das Siliziumsubstrat 1 wird nachfolgend direkt eine Wolframoxidschicht 3' aufgebracht. Diese Wolframoxidschicht 3' wird durch eine CVD-Verfahren erzeugt. Dazu werden Wolframfluorid und Wasser im gasförmigen Zustand als Precusoren auf die Substratoberfläche geführt:

2WF₆ + 4 H₂O → (WOF₄) + WO₃ + (HF) oder

WF₆ + H₂O + Si → W-O + (2HF) + (SiF₄)

Dies führt zur Abscheidung einer etwa 2 bis 20 nm dicke Wolframoxidschicht 3'.

Durch eine nachfolgende Wärmebehandlung bei einer Temperatur von etwa 550 bis 1100°C in einer inerten Atmosphäre läßt sich eine Wolframoxidschicht 3' (WOₓ, beispielsweise x=2 - 3) in einer kristallinen oder gesinterten Phase (beispielsweise Phasen mit einer orthorhombische oder tetragonalen Symmetrie) erzeugen. Diese Wärmebehandlung kann bereits direkt im Anschluß an die Erzeugung der Wolframoxidschicht 3' erfolgen. Sie kann aber auch erst in einem späteren Prozeßschritt in der Herstellung einer integrierten Schaltung durchgeführt werden. Die sich daraus ergebende Situation ist in Fig. 5 gezeigt.

Es folgt die Erzeugung einer leitenden Schicht auf der Wolframoxidschicht 3'. Je nach verwendetem Prozeß kann vor der leitenden Schicht jedoch noch eine weitere Barriereschicht beispielsweise eine Wolframnitridschicht (nicht gezeigt) abgeschieden werden. Die leitenden Schicht und die Wolframoxidschicht 3' können dann wiederum, wie bereits in Zusammenhang mit Figur 4 beschrieben strukturiert werden. Die sich daraus ergebende Situation ist in Fig. 6 gezeigt.

## Patentansprüche

1. Verfahren zur Herstellung eines Halbleiterbauelements, das eine Wolframoxidschicht aufweist, mit den Schritten:
a) eine wolframhaltige Schicht wird bereitgestellt;
b) die wolframhaltige Schicht wird in einer sauerstoffhaltigen Atmosphäre bei einer Temperatur von 500 bis 1200°C thermisch oxidiert; und
c) die Schicht aus Wolframoxid wird nach der thermischen Oxidation einer Wärmebehandlung bei einer Temperatur zwischen 550 bis 1100 °C, bevorzugt 700 bis 1100 °C, in einer inerten Atmosphäre unterzogen, so dass eine Schicht aus Wolframoxid (WOₓ) in einer kristallinen oder gesinterten Phase und mit einer relativen Dielektrizitätskonstante (εᵣ) größer als 50 erzeugt wird.

2. Verfahren nach Anspruch 1, **dadurch gekennzeichnet, dass** als wolframhaltige Schicht eine Schicht aus Wolfram, Wolframsilizid oder Wolframnitrid verwendet wird.

3. Verfahren nach Anspruch 1 oder 2, **dadurch gekennzeichnet, dass** die wolframhaltige Schicht mit einem CVD-Verfahren oder einem PVD-Verfahren bereitgestellt wird.

4. Verfahren zur Herstellung eines Halbleiterbauelements, das eine Wolframoxidschicht aufweist, mit den Schritten:
a) eine Oberfläche des Halbleiterbauelements wird bereitgestellt;
b) Wolframfluorid und Wasser werden im gasförmigen Zustand auf die Oberfläche geführt, so dass eine Schicht aus Wolframoxid (WOₓ) erzeugt wird; und
c) die Schicht aus Wolframoxid wird einer Wärmebehandlung bei einer Temperatur zwischen 550 bis 1100 °C, bevorzugt 700 bis 1100 °C, in einer inerten Atmosphäre unterzogen, so dass eine Schicht aus Wolframoxid (WOₓ) in einer kristallinen oder gesinterten Phase erzeugt wird.

## Claims

1. Process for fabricating a semiconductor component which has a tungsten oxide layer, comprising the following steps:
a) a tungsten-containing layer is provided;
b) the tungsten-containing layer is thermally oxidized in an oxygen-containing atmosphere at a temperature of from 500 to 1200°C and
c) following the thermal oxidation, the layer of tungsten oxide is subjected to a heat treatment at a temperature of between 550 and 1100°C, preferably 700 to 1100°C in an inert atmosphere, so that a layer of tungsten oxide (Woₓ) in a crystalline or sintered phase and with a relative dielectric constant (εᵣ) of greater than 50 is produced.

2. Process according to Claim 1, **characterized in that** the tungsten-containing layer used is a layer of tungsten, tungsten silicide or tungsten nitride.

3. Process according to Claim 1 or 2, **characterized in that** the tungsten-containing layer is provided using a CVD process or a PVD process.

4. Process for fabricating a semiconductor component which has a tungsten oxide layer, comprising the following steps:
a) a surface of the semiconductor component is prepared;
b) tungsten fluoride and water are guided onto the surface in the gaseous state, so that a layer of tungsten oxide (WOₓ) is produced; and
c) the layer of tungsten oxide is subjected to a heat treatment at a temperature of between 550 and 1100°C, preferably 700 to 1100°C in an inert atmosphere, so that a layer of tungsten oxide (WOₓ) in a crystalline or sintered phase is produced.

## Revendications

1. Procédé de fabrication d'un composant à semi-conducteur qui a une couche d'oxyde de tungstène, comprenant les stades dans lesquels :
a) on prépare une couche contenant du tungstène ;
b) on oxyde thermiquement la couche contenant du tungstène dans une atmosphère contenant de l'oxygène à une température de 500 à 1200°C ;
c) on soumet la couche en oxyde de tungstène après l'oxydation thermique à un traitement par la chaleur à une température comprise entre 550 et 1100°C, de préférence entre 700 et 1100°C, dans une atmosphère inerte de manière à produire une couche en oxyde de tungstène (WOₓ) en une phase cristalline ou frittée et ayant une constante (εᵣ) diélectrique relative supérieure à 50.

2. Procédé suivant la revendication 1, **caractérisé en ce que** l'on utilise comme couche contenant du tungstène une couche de tungstène, de siliciure de tungstène ou de nitrure de tungstène.

3. Procédé suivant la revendication 1 ou 2, **caractérisé en ce que** l'on prépare la couche contenant du tungstène, par un procédé CVD par un procédé PVD.

4. Procédé de fabrication d'un composant à semi-conducteur qui a une couche d'oxyde de tungstène, comprenant les stades dans lesquels :
a) on prépare une surface du composant à semi-conducteur ;
b) on envoie sur la surface du fluorure de tungstène et de l'eau à l'état gazeux de manière à produire une couche en oxyde de tungstène (WOₓ) ; et
c) on soumet la couche en oxyde de tungstène à un traitement à la chaleur à une température comprise entre 550 et 1100°C, de préférence entre 700 et 1100°C, dans une atmosphère inerte de manière à produire une couche d'oxyde de tungstène (WOₓ) en une phase cristalline ou frittée.
